# FASCICULE DE BREVET EUROPEEN

(11) **EP 3 979 582 B1**
(45) Date de publication et mention de la délivrance du brevet: **17.04.2024**
(21) Numéro de dépôt: 21198384.6
(22) Date de dépôt: 22.09.2021
(51) Int. Cl.: H04L 27/02, H04L 27/04, H03B 5/12, H03C 1/62, H03L 7/24

(54) **DISPOSITIF DE MODULATION OOK**
VORRICHTUNG ZUR OOK-MODULATION
DEVICE FOR OOK MODULATION

(30) Priorité: 02.10.2020 FR 2010091
(43) Date de publication de la demande: 06.04.2022
(73) Titulaire: Commissariat à l'énergie atomique et aux énergies alternatives, 75015 Paris (FR)
(72) Inventeur: JANY, Clément, 38054 Grenoble Cedex 09 (FR); PELISSIER, Michaël, 38054 Grenoble Cedex 09 (FR)
(74) Mandataire: Brevalex

(56) Documents cités:
- SRIVASTAVA ABHISHEK ET AL: "SAW resonator oscillator based injection locked OOK transmitter for MedRadio spectrum", 2016 14TH IEEE INTERNATIONAL NEW CIRCUITS AND SYSTEMS CONFERENCE (NEWCAS), IEEE, 26 juin 2016 (2016-06-26), pages 1-4, XP032983394, DOI: 10.1109/NEWCAS.2016.7604804
- HAIDER M R ET AL: "A low-voltage low-power injection-locked oscillator for wearable health monitoring systems", ANALOG INTEGRATED CIRCUITS AND SIGNAL PROCESSING, KLUWER ACADEMIC PUBLISHERS, BO, vol. 66, no. 2, 3 septembre 2010 (2010-09-03), pages 145-154, XP019879663, ISSN: 1573-1979, DOI: 10.1007/S10470-010-9513-5
- SILIGARIS ALEXANDRE ET AL: "From ultra-wide-band signals to coherent frequency synthesis", 2014 IEEE INTERNATIONAL CONFERENCE ON ULTRA-WIDEBAND (ICUWB), IEEE, 1 septembre 2014 (2014-09-01), pages 175-179, XP032684141, DOI: 10.1109/ICUWB.2014.6958973

## Description

### DOMAINE TECHNIQUE

L'invention concerne un dispositif de modulation OOK (« On Off Keying » en anglais, ou modulation tout-ou-rien) appliquant une telle modulation à un signal d'entrée. Ce dispositif de modulation est avantageusement utilisé dans un réseau d'émission radiofréquence intégré, par exemple dans le domaine de la communication, du radar, ou de l'imagerie, pour moduler un signal de données à transmettre. Ce dispositif de modulation peut également être utilisé au sein d'un dispositif de synthèse de fréquence.

### ÉTAT DE LA TECHNIQUE ANTÉRIEURE

Les bandes dites millimétriques (fréquences comprises entre environ 30 et 300 GHz) sont utilisées pour les communications haut débit car elles offrent une bande passante élevée, et dans certains cas l'accès à de grandes bandes non-licenciées (par exemple la bande 57-66 GHz). Pour les applications de communications courte portée (plusieurs millimètres à quelques centimètres), la consommation d'énergie est un paramètre très important à considérer, notamment pour les applications nomades (mobiles, tablettes, ...).

La modulation OOK est particulièrement adaptée à ce contexte des communications à haut débit et faible consommation, notamment parce qu'il est possible de démoduler un signal reçu sans avoir recours à une synthèse de fréquence, et ainsi être économe en énergie. L'émetteur réalisant une telle modulation OOK produit un signal modulé composé d'oscillations à la fréquence porteuse pour transmettre des bits ayant une première valeur (par exemple « 1 ») et qui est nul pour transmettre des bits ayant une deuxième valeur (par exemple « 0 »). Les deux méthodes suivantes faisant appel à un oscillateur peuvent être utilisées pour produire un tel signal modulé OOK :
- laisser l'oscillateur en fonctionnement permanent et interrompre sa sortie lors de la transmission d'un bit de la deuxième valeur est transmis ;
- interrompre l'alimentation électrique de l'oscillateur de sorte qu'il s'éteigne lorsqu'un bit de la deuxième valeur est transmis et alimenter de nouveau l'oscillateur lorsqu'un bit de la première valeur est transmis.

Le débit maximum de la communication qu'il est possible d'atteindre en utilisant ces techniques dépend de la vitesse d'ouverture et de fermeture de l'interrupteur pour la première méthode, et de la vitesse d'allumage et d'extinction de l'oscillateur pour la seconde.

Dans le cadre de la seconde méthode, il est possible de déséquilibrer l'oscillateur au moment du démarrage pour le sortir de son état d'équilibre instable et lui permettre ainsi de démarrer plus rapidement.

Le document de M. Tabesh et al., "A Power-Harvesting Pad-Less Millimeter-Sized Radio," in IEEE Journal of Solid-State Circuits, vol. 50, n° 4, pp. 962-977, Avril 2015, décrit l'utilisation d'une paire croisée de transistors nMOS en parallèle d'un réseau LC résistif pour former l'oscillateur. L'allumage et l'extinction de l'oscillateur sont effectués par un transistor se trouvant en pied de la paire croisée. Dans cette configuration, il est possible de déséquilibrer la paire croisée en injectant une impulsion à l'aide d'un transistor supplémentaire placé sur une branche de la paire croisée de transistors, dans le but de diminuer le temps d'établissement des oscillations et d'ainsi avoir accès à des débits plus élevés. Ce déséquilibre peut également être obtenu en utilisant des transistors légèrement différents pour former la paire croisée, ce qui permet de déstabiliser l'équilibre dans lequel se trouve l'oscillateur au démarrage.

Dans certains cas, en modifiant les propriétés de l'impulsion injectée pour démarrer l'oscillateur, il est possible de modifier les conditions de démarrage de l'oscillateur, et notamment sa phase au démarrage. Il est notamment possible, comme montré dans le document EP 2 234 279 A1, de faire en sorte que tous les trains d'oscillations démarrent avec une phase différente, ce qui a pour effet de lisser le spectre du signal. Cette solution peut également être utilisée pour se conformer à un spectre d'émission règlementaire.

Le document SRIVASTAVA ABHISHEK et Al., « SAW resonator oscillator based injection locked OOK transmitter for MedRadio spectrum », 2016 14TH IEEE International New Circuits and Systems Conférence (NEWCAS), IEEE, 26 juin 2016, pages 1-4, décrit un autre type de dispositif de modulation OOK.

### EXPOSÉ DE L'INVENTION

Un but de la présente invention est de proposer un dispositif de modulation OOK ayant de meilleures performances (débit plus important et/ou plus faible consommation électrique) que les dispositifs de l'art antérieur.

Pour cela, l'invention propose un dispositif de modulation OOK d'un signal d'entrée tel que spécifié dans la revendication 1.

Ce dispositif propose de combiner une modulation réalisée par l'allumage et l'extinction de l'alimentation électrique d'un oscillateur et un verrouillage de cet oscillateur sur un signal périodique. L'oscillateur forme un oscillateur à super-régénération (« Super Regeneration Oscillator » en anglais, ou SRO) dont le démarrage est plus rapide qu'un oscillateur ne recevant pas de signal d'injection. Ce dispositif de modulation peut donc réaliser une modulation OOK avec un débit de données plus important sans impacter sa consommation électrique.

L'oscillateur verrouillé par injection comporte au moins :
- un circuit résonant, par exemple de type LC ;
- une paire croisée de transistors à effet de champ couplée électriquement au circuit résonant ;
- deux transistors à effet de champ d'injection, chacun couplé électriquement à l'un des transistors de la paire croisée et dont les grilles forment l'entrée de signal d'injection.

L'oscillateur verrouillé par injection comporte en outre un transistor à effet de champ de déséquilibrage couplé électriquement à l'un des transistors de la paire croisée et dont la grille est configurée pour recevoir un signal d'impulsion destiné à déséquilibrer électriquement l'oscillateur verrouillé par injection lors d'un démarrage de l'oscillateur verrouillé par injection, c'est-à-dire lorsque l'oscillateur verrouillé par injection entre en oscillation et commence à générer un signal sinusoïdal.

Le premier interrupteur commandé peut comporter un transistor à effet de champ dont la grille est couplée électriquement à l'entrée de commande du premier interrupteur commandé et dont la source et le drain sont couplés électriquement à la source d'alimentation électrique et à l'entrée d'alimentation électrique de l'oscillateur verrouillé par injection.

Le dispositif de fourniture de signal périodique peut comporter un oscillateur électrique.

Dans ce cas, l'oscillateur électrique du dispositif de fourniture de signal périodique peut comporter au moins :
- un circuit résonant, par exemple de type LC ;
- une paire croisée de transistors à effet de champ couplée électriquement au circuit résonant de l'oscillateur électrique.

Dans un deuxième mode de réalisation, le dispositif peut comporter en outre :
- un deuxième interrupteur commandé comprenant une entrée de commande sur laquelle le signal d'entrée est destiné à être appliqué, et configuré pour coupler ou non la source d'alimentation électrique à une entrée d'alimentation électrique du dispositif de fourniture de signal périodique ;
- un élément de retard comprenant une entrée sur laquelle le signal d'entrée est destiné à être appliqué et une sortie couplée à l'entrée de commande du premier interrupteur commandé.

Ce deuxième mode de réalisation permet de n'alimenter électriquement le dispositif de fourniture de signal périodique que lorsque l'oscillateur verrouillé par injection doit délivrer le signal modulé OOK avec une valeur non nulle. L'élément de retard permet au dispositif de fourniture de signal périodique de démarrer avant l'oscillateur verrouillé par injection.

L'invention concerne également un dispositif d'émission de signaux radiofréquences, comportant au moins :
- un dispositif de modulation OOK selon l'invention ;
- une antenne d'émission des signaux radiofréquences couplée à la sortie de l'oscillateur verrouillé par injection du dispositif de modulation OOK.

Le dispositif peut comporter en outre au moins un amplificateur comprenant une entrée couplée électriquement à la sortie de l'oscillateur verrouillé par injection du dispositif de modulation OOK et une sortie couplée électriquement à l'antenne.

L'invention concerne également un dispositif de synthèse de fréquence, comportant au moins :
- un dispositif de modulation OOK selon l'invention ;
- un oscillateur comportant une entrée de signal d'injection couplée électriquement à la sortie de l'oscillateur verrouillé par injection du dispositif de modulation OOK.

Un tel dispositif de synthèse de fréquence permet de fournir en sortie un signal stable en fréquence à partir d'un signal de fréquence inférieure. Un tel dispositif de synthèse de fréquence peut être destiné à être utilisé dans un système de communication RF.

Le dispositif de fourniture de signal périodique du dispositif de modulation OOK peut comporter un oscillateur verrouillé par injection, et le dispositif de synthèse de fréquence peut comporter en outre un circuit de génération d'un signal appelé signal TORP et correspondant à des trains d'oscillations répétés périodiquement à une fréquence F_{PRP} dont les oscillations sont de fréquence F₀ > F_{PRP} et dont chaque train d'oscillations a une durée inférieure à 1/F_{PRP}, et une sortie du circuit de génération du signal TORP est couplée électriquement à une entrée de signal d'injection de l'oscillateur verrouillé par injection du dispositif de fourniture de signal périodique du dispositif de modulation OOK.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif de modulation OOK, objet de la présente invention, selon un premier mode de réalisation ;
- la figure 2 représente des signaux obtenus dans un dispositif de modulation OOK, objet de la présente invention, selon le premier mode de réalisation ;
- la figure 3 représente un premier exemple de réalisation d'un dispositif de modulation OOK, objet de la présente invention, selon le premier mode de réalisation ;
- la figure 4 représente un deuxième exemple de réalisation d'un dispositif de modulation OOK, objet de la présente invention, selon le premier mode de réalisation ;
- la figure 5 représente schématiquement un dispositif de modulation OOK, objet de la présente invention, selon un deuxième mode de réalisation ;
- la figure 6 représente des signaux obtenus dans un dispositif de modulation OOK, objet de la présente invention, selon le deuxième mode de réalisation ;
- les figures 7 et 8 représentent des dispositifs d'émission de signaux radiofréquences, objets de la présente invention, selon différents modes de réalisation ;
- la figure 9 représente un dispositif de synthèse de fréquence, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

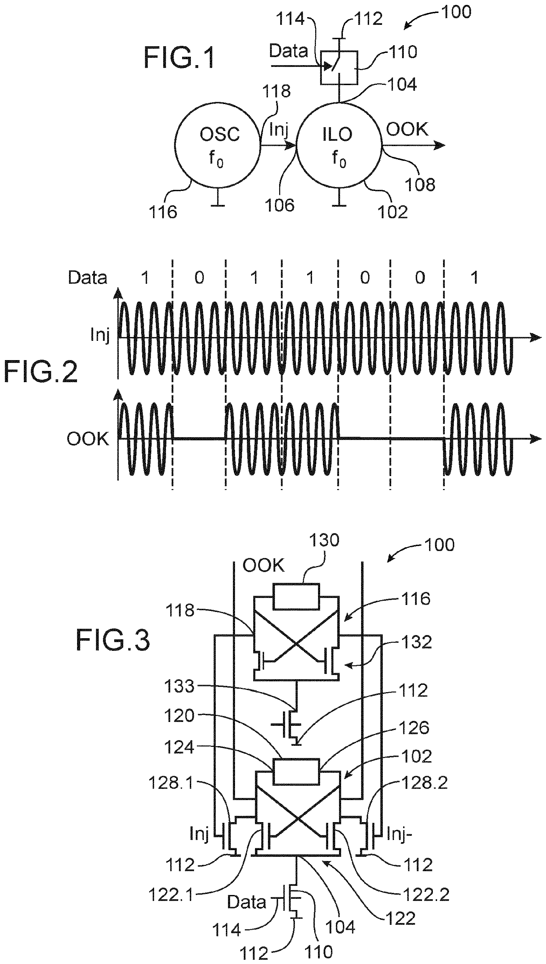

Un dispositif 100 de modulation OOK selon un premier mode de réalisation est décrit ci-dessous en lien avec la figure 1 qui représente schématiquement un tel dispositif 100.

Le dispositif 100 comprend un oscillateur verrouillé par injection, ou ILO, 102. L'ILO 102 comporte une entrée d'alimentation électrique 104, une entrée de signal d'injection 106 et une sortie 108 sur laquelle le signal modulé OOK (nommé « OOK » sur la figure 1) est délivré.

Le dispositif 100 comporte également un interrupteur commandé 110 interposé entre l'entrée d'alimentation électrique 104 de l'ILO 102 et une source d'alimentation électrique 112. L'interrupteur commandé 110 comprend une entrée de commande 114 sur laquelle le signal d'entrée à moduler (nommé « Data » sur la figure 1) est appliqué. Le signal d'entrée à moduler correspond à un signal de données comportant des bits de valeurs « 1 » ou « 0 » et qui est destiné à être modulé par le dispositif 100. L'interrupteur commandé 110 est configuré pour coupler ou non la source d'alimentation électrique 112 à l'entrée d'alimentation électrique 104 de l'ILO 102 en fonction de la valeur des bits du signal d'entrée.

Le dispositif 100 comporte également un dispositif 116 de fourniture de signal périodique configuré pour délivrer sur une sortie 118, qui est couplée électriquement à l'entrée de signal d'injection 106 de l'ILO 102, un signal d'injection périodique (nommé « Inj » sur la figure 1), par exemple sinusoïdal, dont la fréquence f₀ et l'amplitude déclenchent un verrouillage de l'ILO 102 sur la fréquence f₀ du signal d'injection Inj.

Dans l'exemple de réalisation représenté sur la figure 1, le dispositif 116 correspond à un oscillateur électrique. En variante, le signal d'injection Inj peut être fourni par un dispositif 116 qui ne correspond pas à un oscillateur, voire même qui correspond à un simple élément conducteur sur lequel circule le signal d'injection Inj.

Dans ce dispositif 100, l'oscillateur formant le dispositif 116 fournit sur sa sortie 118 le signal d'injection Inj, qui correspond ici à un signal sinusoïdal de fréquence f₀. Ce signal d'injection Inj est appliqué sur l'entrée d'injection 106 de l'ILO 102 et est utilisé comme signal d'injection pour que l'ILO 102 se verrouille sur la fréquence f₀ du signal d'injection Inj. Parallèlement à cela, l'allumage et l'extinction de l'alimentation électrique de l'ILO 102 sont commandés par le signal Data appliqué sur l'entrée de commande 114 de l'interrupteur commandé 110. Selon un premier exemple, un bit « 1 » du signal Data peut mettre l'interrupteur commandé 110 en position fermée qui alimente alors électriquement l'ILO 102, et un bit « 0 » du signal Data peut mettre l'interrupteur commandé 110 en position ouverte afin que l'ILO 102 ne soit plus alimenté électriquement. Selon un deuxième exemple impliquant une conception différente de l'interrupteur commandé 110, un bit « 0 » du signal Data peut mettre l'interrupteur commandé 110 en position fermée qui alimente alors électriquement l'ILO 102, et un bit « 1 » du signal Data peut mettre l'interrupteur commandé 110 en position ouverte afin que l'ILO 102 ne soit plus alimenté électriquement.

La figure 2 représente des exemples des signaux Data, Inj et OOK obtenus lorsqu'un bit « 1 » du signal Data positionne l'interrupteur commandé 110 en position fermée et qu'un bit « 0 » du signal Data positionne l'interrupteur commandé 110 en position ouverte. Sur cette figure, le signal d'injection Inj correspond à un signal sinusoïdal.

Pour que l'ILO 102 puisse se verrouiller sur la fréquence f₀ du signal d'injection Inj, la valeur de la fréquence f₀ et l'amplitude du signal d'injection Inj sont telles que le signal d'injection Inj soit dans la plage de verrouillage, ou zone de sensibilité, de l'ILO 102. Cette condition est vérifiée lorsque la valeur de la fréquence f₀ est égale ou proche de la fréquence d'oscillation libre de l'ILO 102 et que le niveau d'injection, c'est-à-dire l'amplitude du signal d'injection Inj, est suffisant. La capacité de l'ILO 102 à se verrouiller à la fréquence f₀ du signal d'injection peut donc être obtenue en ajustant les valeurs de f₀ et de l'amplitude du signal d'injection Inj, ainsi que celle de la fréquence d'oscillation libre de l'ILO 102.

Le signal OOK obtenu sur la sortie 108 de l'ILO 102 correspond au signal d'entrée Data modulé selon une modulation OOK à la fréquence f₀, c'est-à-dire formé d'oscillations de fréquence f₀ lorsque le signal d'entrée Data ferme l'interrupteur commandé 110 (lorsque la valeur du bit est « 1 » sur l'exemple de la figure 2) et nul lorsque le signal d'entrée Data ouvre l'interrupteur commandé 110 (lorsque la valeur du bit est « 0 » sur l'exemple de la figure 2).

Afin d'obtenir une modulation correcte du signal d'entrée, le rapport entre la durée de chaque bit du signal d'entrée Data et la période du signal d'injection Inj est strictement supérieur à 2.

Dans le dispositif 100, le verrouillage de l'ILO 102 à la fréquence f₀ du signal d'injection Inj permet d'obtenir un démarrage très rapide de l'ILO 102 lorsque le signal d'entrée Data ferme l'interrupteur commandé 110 grâce au phénomène de super-régénération se produisant dans l'ILO 102, le temps de démarrage de l'ILO 102 étant accéléré grâce à l'énergie injectée par le signal d'injection Inj.

Un premier exemple de réalisation du dispositif 100 est décrit ci-dessous et est représenté sur la figure 3.

Dans ce premier exemple de réalisation, l'ILO 102 comporte un circuit résonant 120, par exemple de type LC et comportant au moins une inductance et une capacité couplée l'une à l'autre en série ou en parallèle.

L'ILO 102 comporte également une paire croisée 122 de transistors à effet de champ, ici des MOSFET de type n, couplée au circuit résonant 120. Les transistors de cette paire croisée 122 portent les références 122.1 et 122.2. Le transistor 122.1 comporte son drain couplé à celui du transistor 122.2, sa source couplée à une première borne 124 du circuit résonant 120 et sa grille couplée à une deuxième borne 126 du circuit résonant 120. Le transistor 122.2 comporte sa source couplée à la deuxième borne 126 du circuit résonant 120 et sa grille couplée à la première borne 124 du circuit résonant 120. Les drains des transistors 122.1, 122.2 forment l'entrée d'alimentation électrique 104 de l'ILO 102.

L'ILO 102 comporte également deux transistors à effet de champ appelés transistors d'injection 128.1 et 128.2. Dans le premier exemple de réalisation représenté sur la figure 3, les transistors d'injection 128.1 et 128.2 correspondent à des MOSFET de type n. Chacun des transistors d'injection 128.1, 128.2 est couplé électriquement à l'un des transistors 122.1, 122.2 de la paire croisée 122 et les grilles des transistors d'injection 128.1, 128.2 forment l'entrée d'injection 106 de l'ILO 102. Sur la figure 3, le transistor 128.1 comporte son drain couplé à la source d'alimentation électrique 112 du dispositif 100, sa source couplée à celle du transistor 122.1, et le signal d'injection Inj est appliqué sur sa grille. Le transistor 128.2 comporte son drain couplé à la source d'alimentation électrique 112 du dispositif 100, sa source couplée à celle du transistor 122.2, et un signal Inj-, de valeur complémentaire de celle du signal d'injection Inj, est appliqué sur sa grille.

Sur l'exemple de la figure 3, l'interrupteur commandé 110 est formé par un transistor à effet de champ, ici un MOSFET de type n, comportant son drain couplé à la source d'alimentation électrique 112 du dispositif 100, sa source couplée à l'entrée d'alimentation électrique 104 de l'ILO 102, et sa grille formant l'entrée de commande 114 sur laquelle le signal d'entrée Data est appliqué.

Sur l'exemple de la figure 3, le dispositif 116 de fourniture de signal périodique correspond à un oscillateur formé par un circuit résonant 130 par exemple similaire au circuit résonant 120 de l'ILO 102, et une paire croisée 132 de transistors à effet de champ, couplée au circuit résonant 130. Le circuit résonant 130 est par exemple de type LC comme dans l'exemple de réalisation du circuit résonant 120 précédemment décrit. La paire croisée 132 est par exemple similaire à la paire croisée 122 de l'ILO 102 et est couplée au circuit résonant 130 de la même manière que la paire croisée 122 avec le circuit résonant 120. Le signal d'injection Inj est obtenu sur l'une des deux bornes du circuit résonant 130 qui est couplée à la grille du transistor 128.1 et qui forme la sortie 118 du dispositif 116, et le signal Inj- est obtenu sur l'autre des deux bornes du circuit résonant 130 qui est couplée à la grille du transistor 128.2. Le circuit résonant 130 et la paire croisée 132 sont alimentés électriquement par l'intermédiaire d'un transistor 133 qui comporte son drain couplé à la source d'alimentation électrique 112 du dispositif 100 et sa source couplée aux drains des transistors de la paire croisée 132. Ce transistor 133 est à l'état passant lors du fonctionnement du dispositif 100.

Le signal OOK obtenu en sortie du dispositif 100 correspond au signal obtenu sur la première borne 124 du circuit résonant 120. Un signal complémentaire du signal OOK est obtenu sur la deuxième borne 126 du circuit résonant 120.

Selon un exemple de mise en oeuvre, le signal d'entrée Data a un débit binaire égal à 20 Gbps (avec codage NRZ ou non-retour à zéro), la fréquence f₀ du signal d'injection Inj est égale à 60 GHz.

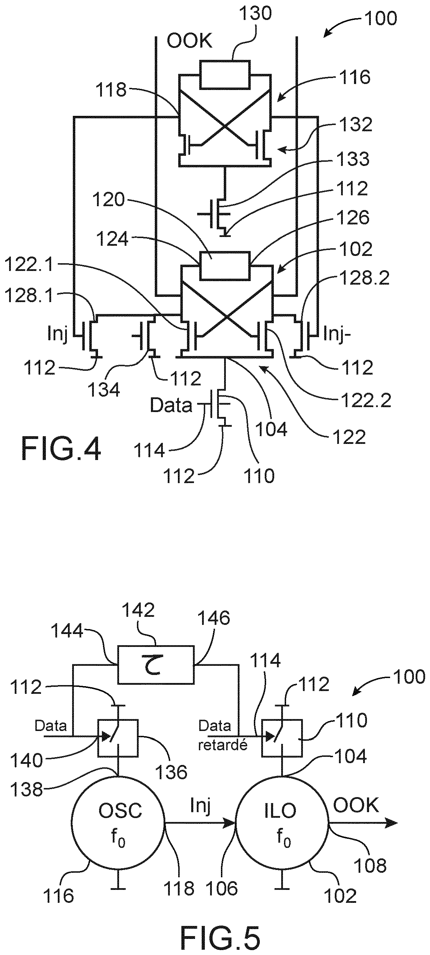

Un deuxième exemple de réalisation du dispositif 100 est décrit ci-dessous et représenté sur la figure 4.

Dans ce deuxième exemple de réalisation, le dispositif 100 comporte tous les éléments du dispositif 100 selon le premier exemple de réalisation précédemment décrit en lien avec la figure 3.

Outre ces éléments, le dispositif 100 selon le deuxième exemple de réalisation comporte un élément supplémentaire permettant d'injecter, dans l'ILO 102, une impulsion électrique déséquilibrant l'ILO 102 au moment de son démarrage pour le sortir de son état d'équilibre instable et lui permettre de démarrer plus rapidement. Sur l'exemple de la figure 4, cet élément supplémentaire correspond à un transistor 134 à effet de champ, par exemple un MOSFET de type n, couplé à l'un des transistors de la paire croisée 122 (le transistor 122.1 sur l'exemple de la figure 4) et dont la grille reçoit un signal d'impulsion destiné à déséquilibrer électriquement l'ILO 102 lors du démarrage de l'ILO 102. Le transistor 134 est couplé en parallèle du transistor d'injection 128.1, c'est-à-dire comporte son drain couplé à la source d'alimentation électrique 112 du dispositif 100 et sa source couplée à celle du transistor d'injection 128.1.

Un dispositif 100 de modulation OOK selon un deuxième mode de réalisation est décrit ci-dessous en lien avec la figure 5 qui représente schématiquement un tel dispositif 100.

Comme dans le premier mode de réalisation, le dispositif 100 comporte l'ILO 102, l'interrupteur commandé 110 et le dispositif 116 de fourniture du signal d'injection Inj.

Le dispositif 100 selon le deuxième mode de réalisation comporte en outre un deuxième interrupteur commandé 136 couplé entre une entrée d'alimentation électrique 138 du dispositif 116 et la source d'alimentation électrique 112. Le deuxième interrupteur commandé 136 comprend une entrée de commande 140 sur laquelle le signal d'entrée Data est appliqué. Lorsque le dispositif 100 est réalisé selon le premier ou le deuxième exemple de réalisation précédemment décrits en lien avec les figures 3 et 4, le deuxième interrupteur commandé 136 correspond au transistor 133 et l'entrée d'alimentation électrique 138 est formée par les drains des transistors de la paire croisée 132.

Le dispositif 100 selon le deuxième mode de réalisation comporte également un élément à retard 142 comprenant une entrée 144 sur laquelle le signal d'entrée Data est appliqué et une sortie 146 couplée à l'entrée de commande 114 du premier interrupteur commandé 110. Le retard τ appliqué au signal d'entrée Data est inférieur à la durée d'un bit du signal d'entrée Data.

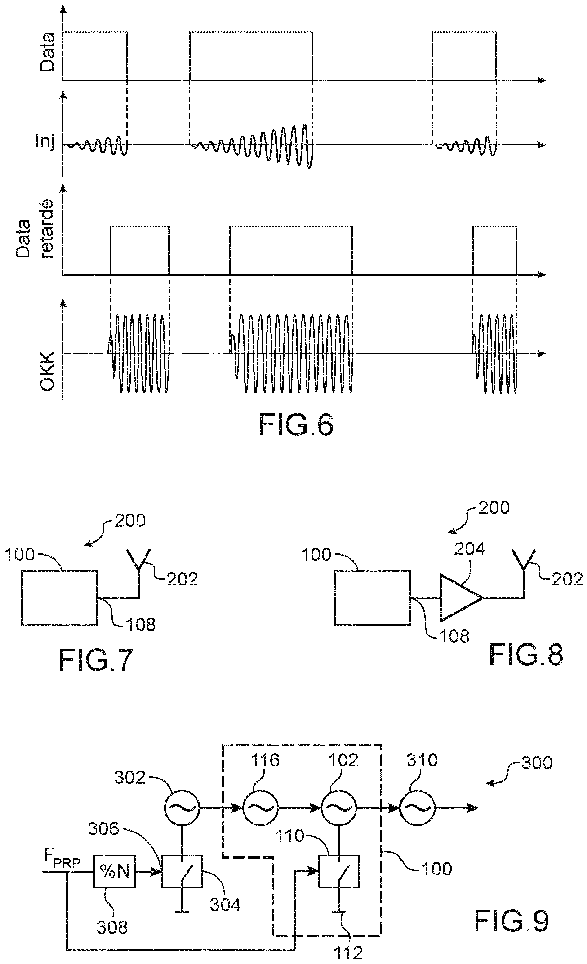

La figure 6 représente des exemples des signaux Data, Inj, Data retardé et OOK obtenus lorsqu'un bit « 1 » des signaux Data et Data retardé positionne les interrupteurs commandés 110 et 140 en position fermée. Sur cette figure, l'augmentation lente de l'amplitude du signal Inj est représentée de manière très schématique pour illustrer le fait que même si l'amplitude des oscillations du signal Inj n'atteint pas la valeur attendue au régime établit, ces oscillations vont quand même contribuer au démarrage rapide du modulateur. Sur cette figure, le signal d'injection Inj correspond à un signal pulsé. Plus généralement, le signal d'injection Inj peut correspondre à un signal « pseudosinusoïdal », par exemple formé de portions de sinusoïdes.

Dans ce deuxième mode de réalisation, le dispositif 116 n'est pas alimenté électriquement de manière continue comme dans le premier mode de réalisation, mais que lorsque le deuxième interrupteur commandé 136 est fermé par le signal d'entrée Data (lorsque la valeur des bits est égale « 1 » sur l'exemple de la figure 5). Ce deuxième mode de réalisation permet, par rapport au premier mode de réalisation, de réduire la consommation électrique du dispositif 100.

Dans les différents modes et exemples de réalisation décrits ci-dessus, l'ILO 102 se verrouille sur la fréquence f₀ du signal d'injection Inj qui est égale ou proche de la fréquence d'oscillation libre de l'ILO 102. En variante, il est possible que la fréquence f₀ du signal d'injection sur laquelle se verrouille l'ILO 102 corresponde à un multiple de la fréquence d'oscillation libre de l'ILO 102, c'est-à-dire une des fréquences harmoniques de la fréquence d'oscillation libre de l'ILO 102, ou à un sous-multiple de la fréquence d'oscillation libre de l'ILO 102, c'est-à-dire une des fréquences sousharmoniques de la fréquence d'oscillation libre de l'ILO 102. Lorsque la fréquence f₀ de verrouillage de l'ILO 102 correspond à un sous-multiple de la fréquence d'oscillation libre de l'ILO 102, la consommation électrique du dispositif 100 est réduite par rapport aux cas aux cas où la fréquence f₀ de verrouillage de l'ILO 102 correspond à la fréquence d'oscillation libre de l'ILO 102 ou un multiple de la fréquence d'oscillation libre de l'ILO 102.

Plusieurs exemples d'applications du dispositif de modulation OOK 100 sont décrits ci-dessous.

Les figures 7 et 8 représentent des dispositifs d'émission de signaux radiofréquences 200 selon deux modes de réalisation. Chacun des dispositifs 200 comporte un dispositif 100 de modulation OOK tel que précédemment décrit. Sur la figure 7, la sortie 108 de l'ILO 102 du dispositif 100 est couplée à une antenne 202 réalisant l'émission du signal modulé OOK délivré sur la sortie 108. Sur la figure 8, la sortie 108 de l'ILO 102 du dispositif 100 est couplée à l'entrée d'un amplificateur 204 et la sortie de l'amplificateur 204 est couplée à l'antenne 202.

La figure 9 représente un dispositif de synthèse de fréquence 300 selon un mode de réalisation particulier.

Le dispositif 300 comporte un premier oscillateur 302 alimenté électriquement par l'intermédiaire d'un interrupteur commandé 304 recevant sur une entrée de commande 306 un signal de commande périodique de fréquence f_{PRP}/N, avec N nombre entier supérieur à 1. Ce signal de commande est obtenu en sortie d'un diviseur de fréquence 308 sur lequel un signal périodique de fréquence f_{PRP} est appliqué en entrée et appliquant un facteur de division égal à N au signal de fréquence f_{PRP}. Ce diviseur de fréquence est utilisé du fait que le premier oscillateur 302 ne reçoit pas de signal d'injection et que la fréquence f_{PRP} est trop grande pour pouvoir être utilisée avec un tel oscillateur. Dans cette configuration, le premier oscillateur 302 génère en sortie un signal appelé TORP (« Train d'Oscillations Répétées Périodiquement ») correspondant à un train d'oscillations de fréquence sensiblement égale à f₀ (avec f₀ > f_{PRP}/N), de durée inférieure à T = N/f_{PRP} et répété périodiquement à la fréquence f_{PRP}/N. Des détails de fonctionnement d'un dispositif de génération de signal TORP sont donnés dans le document EP 2 786 492 B1.

Le dispositif 300 comporte également un dispositif 100 de modulation selon l'une des modes de réalisation précédemment décrits. Le signal TORP délivré par le premier oscillateur 302 est envoyé en entrée du dispositif 116 du dispositif 100, ce dispositif 116 correspondant à un oscillateur sur l'exemple de la figure 9. L'oscillateur 116 délivre en sortie un signal d'injection périodique, qui est par exemple sinusoïdal de fréquence f₀. Le signal de fréquence f_{PRP} est appliqué sur l'entrée de commande de l'interrupteur commandé 110. Le signal délivré en sortie du dispositif 100 correspond au signal de fréquence f_{PRP} modulé OOK à la fréquence f₀. Ce signal délivré en sortie du dispositif 100 correspond à un signal TORP cohérent, c'est-à-dire dont la phase au démarrage de chaque train d'oscillations est toujours la même.

Le dispositif 300 comporte également un deuxième oscillateur 310 recevant en entrée le signal délivré par le dispositif 100 et délivrant sortie un signal sinusoïdal de fréquence f₀.

Le dispositif 300 ainsi réalisé permet de synthétiser un signal sinusoïdal de fréquence égale à f₀.

Ce dispositif 300 apporte plus de flexibilité dans la génération du plan de fréquences car la plage de verrouillage du dispositif 116 est dimensionnée pour que les harmoniques de la fréquence FPRP/n tombent dans la bande de verrouillage du dispositif 116.

Quel que soit l'exemple de réalisation du dispositif 100, le signal d'injection périodique peut être sinusoïdal ou non.

En outre, les circuits résonants 120 et 130 peuvent correspondre à des circuits résonants de type LC ou de type différent. Par exemple, au moins l'un des circuits résonants 120, 130 peut correspondre à un circuit résonant astable par exemple formé par un système sur lequel est appliquée une rétroaction et qui se trouve en limite de stabilité.

### REFERENCES CITEES

1 : M. Tabesh et al., "A Power-Harvesting Pad-Less Millimeter-Sized Radio," in IEEE Journal of Solid-State Circuits, vol. 50, n° 4, pp. 962-977, Avril 2015.
2 : EP 2 234 279 A1.
3 : EP 2 786 492 B1.

## Revendications

1. Dispositif (100) de modulation tout-ou-rien, On-Off Keying, OOK, en anglais, d'un signal d'entrée, comprenant au moins :
- un oscillateur verrouillé par injection (102) comprenant une entrée d'alimentation électrique (104), une entrée de signal d'injection (106) et une sortie (108) sur laquelle le signal modulé OOK est destiné à être délivré ;
- un premier interrupteur commandé (110) comprenant une entrée de commande (114) sur laquelle le signal d'entrée est destiné à être appliqué, et configuré pour coupler ou non une source d'alimentation électrique (112) à l'entrée d'alimentation électrique (104) de l'oscillateur verrouillé par injection (102) en fonction de la valeur du signal d'entrée;
- un dispositif (116) de fourniture de signal périodique configuré pour délivrer sur une sortie (118), qui est couplée électriquement à l'entrée de signal d'injection (106) de l'oscillateur verrouillé par injection (102), un signal d'injection périodique dont la fréquence et l'amplitude déclenchent un verrouillage de l'oscillateur verrouillé par injection (102) sur la fréquence du signal d'injection ou un multiple de la fréquence du signal d'injection ;
dans lequel l'oscillateur verrouillé par injection (102) comporte au moins :
- un circuit résonant (120) ;
- une paire croisée (122) de transistors à effet de champ (122.1, 122.2) couplée électriquement au circuit résonant (120) ;
- deux transistors à effet de champ d'injection (128.1, 128.2), chacun couplé électriquement à l'un des transistors (122.1, 122.2) de la paire croisée (122) et dont les grilles forment l'entrée de signal d'injection (106) ;
**caractérisé en ce que** l'oscillateur verrouillé par injection (102) comporte en outre un transistor à effet de champ de déséquilibrage (134) couplé électriquement à l'un des transistors (122.1) de la paire croisée (122) et dont la grille est configurée pour recevoir un signal d'impulsion destiné à déséquilibrer électriquement l'oscillateur verrouillé par injection (102) lors d'un démarrage de l'oscillateur verrouillé par injection (102).

2. Dispositif (100) selon la revendication 1, dans lequel le circuit résonant (120) est de type LC.

3. Dispositif (100) selon l'une des revendications précédentes, dans lequel le premier interrupteur commandé (110) comporte un transistor à effet de champ dont la grille est couplée électriquement à l'entrée de commande (114) du premier interrupteur commandé (110) et dont la source et le drain sont couplés électriquement à la source d'alimentation électrique (112) et à l'entrée d'alimentation électrique (104) de l'oscillateur verrouillé par injection (102).

4. Dispositif (100) selon l'une des revendications précédentes, dans lequel le dispositif (116) de fourniture de signal périodique comporte un oscillateur électrique.

5. Dispositif (100) selon la revendication 4, dans lequel l'oscillateur électrique du dispositif (116) de fourniture de signal périodique comporte au moins :
- un circuit résonant (130) ;
- une paire croisée (132) de transistors à effet de champ couplée électriquement au circuit résonant (130) de l'oscillateur électrique.

6. Dispositif (100) selon la revendication 5, dans lequel le circuit résonant (130) est de type LC.

7. Dispositif (100) selon l'une des revendications précédentes, comportant en outre :
- un deuxième interrupteur commandé (136) comprenant une entrée de commande (140) sur laquelle le signal d'entrée est destiné à être appliqué, et configuré pour coupler ou non la source d'alimentation électrique (112) à une entrée d'alimentation électrique (138) du dispositif (116) de fourniture de signal périodique ;
- un élément de retard (142) comprenant une entrée (144) sur laquelle le signal d'entrée est destiné à être appliqué et une sortie (146) couplée à l'entrée de commande (114) du premier interrupteur commandé (110).

8. Dispositif (100) selon l'une des revendications précédentes, dans lequel le signal d'injection périodique correspond à un signal sinusoïdal.

9. Dispositif (200) d'émission de signaux radiofréquences, comportant au moins :
- un dispositif (100) de modulation OOK selon l'une des revendications précédentes ;
- une antenne (202) d'émission des signaux radiofréquences couplée à la sortie (108) de l'oscillateur verrouillé par injection (102) du dispositif (100) de modulation OOK.

10. Dispositif (200) selon la revendication 9, comportant en outre au moins un amplificateur (204) comprenant une entrée couplée électriquement à la sortie (108) de l'oscillateur verrouillé par injection (102) du dispositif (100) de modulation OOK et une sortie couplée électriquement à l'antenne (202).

11. Dispositif (300) de synthèse de fréquence, comportant au moins :
- un dispositif (100) de modulation OOK selon l'une des revendications 1 à 8 ;
- un oscillateur (310) comportant une entrée de signal d'injection couplée électriquement à la sortie (108) de l'oscillateur verrouillé par injection (102) du dispositif (100) de modulation OOK.

12. Dispositif (300) selon la revendication 11, dans lequel le dispositif (116) de fourniture de signal périodique du dispositif (100) de modulation OOK comporte un oscillateur verrouillé par injection, et comportant en outre un circuit (302, 304, 306, 308) de génération d'un signal TORP correspondant à des trains d'oscillations répétés périodiquement à une fréquence F_{PRP} dont les oscillations sont de fréquence F₀ > F_{PRP} et dont chaque train d'oscillations a une durée inférieure à 1/F_{PRP}, et dans lequel une sortie du circuit (302, 304, 306, 308) de génération du signal TORP est couplée électriquement à une entrée de signal d'injection de l'oscillateur verrouillé par injection (116) du dispositif de fourniture de signal périodique du dispositif (100) de modulation OOK.

## Patentansprüche

1. Vorrichtung (100) zur Ein-Aus-Modulation, On-Off Keying, OOK, auf Englisch, eines Eingangssignals, mindestens umfassend:
- einen durch Injektion stabilisierten Oszillator (102), der einen Stromversorgungseingang (104), einen Injektionssignaleingang (106) und einen Ausgang (108) umfasst, an den das modulierte OOK-Signal geliefert werden soll;
- einen ersten gesteuerten Schalter (110), der einen Steuereingang (114) umfasst, an den das Eingangssignal angelegt werden soll, und der konfiguriert ist, um eine Stromversorgungsquelle (112) mit dem Stromversorgungseingang (104) des durch Injektion (102) stabilisierten Oszillators in Abhängigkeit vom Wert des Eingangssignals zu koppeln oder nicht;
- eine Vorrichtung (116) zur Bereitstellung eines periodischen Signals, die konfiguriert ist, um an einen Ausgang (118), der elektrisch mit dem Injektionssignaleingang (106) des durch Injektion stabilisierten Oszillators (102) gekoppelt ist, ein periodisches Injektionssignal zu liefern, dessen Frequenz und Amplitude eine Stabilisierung des durch Injektion (102) stabilisierten Oszillators an der Frequenz des Injektionssignals auslösen oder ein Mehrfaches der Frequenz des Injektionssignals;
wobei der durch Injektion stabilisierte Oszillator (102) mindestens beinhaltet:
- eine Resonanzschaltung (120);
- ein überkreuztes Paar (122) von Feldeffekttransistoren (122.1, 122.2), das elektrisch mit der Resonanzschaltung (120) gekoppelt ist;
- zwei Injektions-Feldeffekttransistoren (128.1, 128.2), die jeweils elektrisch mit einem der Transistoren (122.1, 122.2) des überkreuzten Paares (122) gekoppelt sind, und deren Gates den Injektionssignaleingang (106) bilden;
**dadurch gekennzeichnet, dass** der durch Injektion (102) stabilisierte Oszillator ferner einen Unsymmetrie-Feldeffekttransistor (134) beinhaltet, der elektrisch mit einem der Transistoren (122.1) des überkreuztes Paares (122) gekoppelt ist, und dessen Gate konfiguriert ist, um ein Impulssignal zu empfangen, das dazu bestimmt ist, den durch Injektion (102) stabilisierten Oszillator beim Einschalten des durch Injektion (102) stabilisierten Oszillators elektrisch aus der Symmetrie zu bringen.

2. Vorrichtung (100) nach Anspruch 1, wobei die Resonanzschaltung (120) vom Typ LC ist.

3. Vorrichtung (100) nach einem der vorhergehenden Ansprüche, wobei der erste gesteuerte Schalter (110) einen Feldeffekttransistor beinhaltet, dessen Gate elektrisch mit dem Steuereingang (114) des ersten gesteuerten Schalters (110) gekoppelt ist, und dessen Source und Drain elektrisch mit der Stromversorgungsquelle (112) und dem Stromversorgungseingang (104) des durch Injektion stabilisierten Oszillators (102) gekoppelt sind.

4. Vorrichtung (100) nach einem der vorhergehenden Ansprüche, wobei die Vorrichtung (116) zur Bereitstellung eines periodischen Signals einen elektrischen Oszillator beinhaltet.

5. Vorrichtung (100) nach Anspruch 4, wobei der elektrische Oszillator der Vorrichtung (116) zur Bereitstellung eines periodischen Signals mindestens beinhaltet:
- eine Resonanzschaltung (130);
- ein überkreuztes Paar (132) von Feldeffekttransistoren, das elektrisch mit der Resonanzschaltung (130) des elektrischen Oszillators gekoppelt ist.

6. Vorrichtung (100) nach Anspruch 5, wobei die Resonanzschaltung (130) vom Typ LC ist.

7. Vorrichtung (100) nach einem der vorhergehenden Ansprüche, ferner beinhaltend:
- einen zweiten gesteuerten Schalter (136), einen Steuereingang (140) umfassend, an den das Eingangssignal angelegt werden soll, und der konfiguriert ist, um die Stromversorgungsquelle (112) mit einem Stromversorgungseingang (138) der Vorrichtung (116) zur Bereitstellung eines periodischen Signals zu koppeln oder nicht;
- ein Verzögerungselement (142), einen Eingang (144) umfassend, an den das Eingangssignal angelegt werden soll, und einen Ausgang (146), der mit dem Steuereingang (114) des ersten gesteuerten Schalters (110) gekoppelt ist.

8. Vorrichtung (100) nach einem der vorhergehenden Ansprüche, wobei das periodische Injektionssignal einem sinusförmigen Signal entspricht.

9. Vorrichtung (200) zum Senden von Funkfrequenzsignalen, mindestens beinhaltend:
- eine Vorrichtung (100) zur OOK-Modulation nach einem der vorhergehenden Ansprüche;
- eine Antenne (202) zum Senden von Funkfrequenzsignalen, die mit dem Ausgang (108) des durch Injektion (102) stabilisierten Oszillators der Vorrichtung (100) zur OOK-Modulation gekoppelt ist.

10. Vorrichtung (200) nach Anspruch 9, ferner mindestens einen Verstärker (204) beinhaltend, der einen Eingang umfasst, der elektrisch mit dem Ausgang (108) des durch Injektion stabilisierten Oszillators (102) der Vorrichtung (100) zur OOK-Modulation gekoppelt ist, und einen Ausgang, der elektrisch mit der Antenne (202) gekoppelt ist.

11. Vorrichtung (300) zur Frequenzsynthese, mindestens beinhaltend:
- eine Vorrichtung (100) zur OOK-Modulation nach einem der Ansprüche 1 bis 8;
- einen Oszillator (310), einen Injektionssignaleingang beinhaltend, der elektrisch mit dem Ausgang (108) des durch Injektion stabilisierten Oszillators (102) der Vorrichtung (100) zur OOK-Modulation gekoppelt ist.

12. Vorrichtung (300) nach Anspruch 11, wobei die Vorrichtung (116) zur Bereitstellung eines periodischen Signals der Vorrichtung (100) zur OOK-Modulation einen durch Injektion stabilisierten Oszillator beinhaltet und ferner eine Schaltung (302, 304, 306, 308) zur Erzeugung eines TORP-Signals beinhaltet, das periodisch wiederholten Folgen von Oszillationen mit einer F_{PRP}-Frequenz entspricht, deren Oszillationen die Frequenz F₀ > F_{PRP} haben, und deren jede Folge von Oszillationen eine Dauer von weniger als 1/F_{PRP} hat, und wobei ein Ausgang der Schaltung (302, 304, 306, 308) der Erzeugung des TORP-Signals elektrisch mit einem Injektionssignaleingang des durch Injektion stabilisierten Oszillators (116) der Vorrichtung zur Bereitstellung eines periodischen Signals der Vorrichtung (100) zur OOK-Modulation gekoppelt ist.

## Claims

1. A device for On-Off keying, OOK, modulating an input signal, comprising at least:
- an injection-locked oscillator (102) comprising a power supply input (104), an injection signal input (106) and an output (108) to which the modulated OOK signal is to be delivered;
- a first controlled switch (110) comprising a control input (114) to which the input signal is to be applied, and configured to couple or not a power supply source (112) to the power supply input (104) of the injection-locked oscillator (102) in dependence on the value of the input signal;
- a periodic signal providing device (116) configured to deliver, on an output (118) which is electrically coupled to the injection signal input (106) of the injection-locked oscillator (102), a periodic injection signal whose frequency and amplitude trigger locking of the injection-locked oscillator (102) to the frequency of the injection signal or a multiple of the frequency of the injection signal;
wherein the injection-locked oscillator (102) includes at least:
- a resonant circuit (120);
- a cross-coupled pair (122) of field effect transistors (122.1,122.2) electrically coupled to the resonant circuit (120); and
- two injection field effect transistors (128.1,128.2), each electrically coupled to one of the transistors (122.1,122.2) of the cross-coupled pair (122) and whose gates form the injection signal input (106);
**characterized in that** the injection-locked oscillator (102) further comprises an unbalancing field effect transistor (134) electrically coupled to one of the transistors (122.1) of the cross-coupled pair (122) and whose gate is configured to receive a pulse signal for electrically unbalancing the injection-locked oscillator (102) upon starting up the injection-locked oscillator (102).

2. The device (100) according to claim 1, wherein the resonant circuit (120) is of the LC type.

3. The device (100) according to one of the preceding claims, wherein the first controlled switch (110) includes a field effect transistor whose gate is electrically coupled to the control input (114) of the first controlled switch (110) and whose source and drain are electrically coupled to the power supply source (112) and the power supply input (104) of the injection-locked oscillator.

4. The device (100) according to one of the preceding claims, wherein the periodic signal providing device (116) includes an electrical oscillator.

5. The device (100) according to claim 4, wherein the electrical oscillator of the periodic signal providing device (116) includes at least:
- a resonant circuit (130);
- a cross-coupled pair (132) of field effect transistors electrically coupled to the resonant circuit (130) of the electrical oscillator.

6. The device (100) according to claim 5, wherein the resonant circuit (130) is of the LC type.

7. The device (100) according to one of the preceding claims, further including:
- a second controlled switch (136) comprising a control input (140) to which the input signal is to be applied, and configured to couple or not the power supply source (112) to a power supply input (138) of the periodic signal providing device (116);
- a delay element (142) comprising an input (144) to which the input signal is to be applied and an output (146) coupled to the control input (114) of the first controlled switch (110).

8. The device (100) according to one of the preceding claims, wherein the periodic injection signal corresponds to a sinusoidal signal.

9. A device (200) for transmitting radio frequency signals, including at least:
- an OOK modulation device (100) according to one of the preceding claims;
- a radio frequency signal transmission antenna (202) coupled to the output (108) of the injection-locked oscillator (102) of the OOK modulation device (100).

10. The device (200) according to claim 9, further including at least one amplifier (204) comprising an input electrically coupled to the output (108) of the injection-locked oscillator (102) of the OOK modulation device (100) and an output electrically coupled to the antenna (202).

11. A frequency synthesis device (300), including at least:
- an OOK modulation device (100) according to one of claims 1 to 8;
- an oscillator (310) including an injection signal input electrically coupled to the output (108) of the injection-locked oscillator (102) of the OOK modulation device (100).

12. The device (300) according to claim 11, wherein the periodic signal providing device (116) of the OOK modulation device (100) includes an injection-locked oscillator, and further including a circuit (302, 304, 306, 308) for generating a PROT signal corresponding to trains of periodically repeated oscillations at a frequency F_{PRP} whose oscillations are of frequency F0 > F_{PRP} and each train of oscillations of which has a duration less than 1/F_{PRP}, and wherein an output of the prot signal generating circuit (302, 304, 306, 308)is electrically coupled to an injection signal input of the injection-locked oscillator (116) of the periodic signal providing device of the OOK modulation device (100).
